Europäisches Patentamt

European Patent Office

Office européen des brevets

(19)

(11) EP 1 443 640 A1

(12) EUROPEAN PATENT APPLICATION

(43) Date of publication:
04.08.2004 Bulletin 2004/32

(51) Int Cl.7: H03B 1/04

(21) Application number: 03425048.0

(22) Date of filing: 29.01.2003

(84) Designated Contracting States:
AT BE BG CH CY CZ DE DK EE ES FI FR GB GR
HU IE IT LI LU MC NL PT SE SI SK TR
Designated Extension States:
AL LT LV MK RO

(71) Applicant: Siemens Mobile Communications
S.p.A.
20126 Milano (IT)

(72) Inventor: Colosimo, Aurelio
20133 Milan (IT)

(54) **Reference oscillator phase noise compensation circuitry**

(57) A phase noise compensation circuitry is connectible to a reference oscillator (14) which generates a reference signal, affected by phase noise $\varphi(t)$, exploitable either for modulation, demodulation, or simply frequency conversion. The compensation circuitry includes an mixer (17) which receives the reference signal, and a copy of the reference signal after $\pi/2$ phase shifting and delaying by a fixed delay $\tau$ spanning an integer number $N$ of periods of the reference signal. The baseband signal at the output of the mixer (17) is proportional to the time derivative of the phase noise voltage. In a preferred embodiment the baseband signal is filtered and A/D converted before reaching a downstream numerical integrator (21) which provides a phase noise estimation voltage proportional to the difference between the phase noise voltage across the delay $\tau$. The delay $\tau$ also spans an integer $L<N$ periods of the digital clock: $L=1$ is the preferred value. The output of the integrator (21), opportunely scaled out, acts as an address $\varphi$ of two look-up tables (23, 24) for obtaining in correspondence respective digital samples $sin(\varphi)$ and $cos(\varphi)$. These digital samples are sent to a complex multiplier (11) which carries out the following digital products: $\widetilde{s}_I(r)=[s_I(r)\cdot cos\varphi]$ and $\widetilde{s}_Q(r)=[s_Q(r)\cdot sin\varphi]$, in order to perform a digital compensation of the phase noise due to the reference signal. In case the compensation circuit is used by the transmitter the $\widetilde{s}_I(r)$, $\widetilde{s}_Q(r)$ products are In-phase and In-quadrature phase-noise precompensated modulating components. In case the compensation circuit is used by the receiver the $\widetilde{s}_I(r)$, $\widetilde{s}_Q(r)$ products are In-phase and In-quadrature phase-noise postcompensated demodulated components (fig.2).

TRANSMITTER FOR DIGITAL MODULATION AND
DIGITAL PHASE NOISE PRECOMPENSATION

FIG. 2

$s_o(t) = cos(\omega_o t + \varphi(t))$

## Description

### FIELD OF THE INVENTION

The present invention relates to the field of the transmission and reception of bandpass RF modulated signals and more precisely to a reference oscillator phase noise compensation circuitry.

### BACKGROUND ART

Severe quality requirements are nowadays imposed to the reference oscillators used in professional apparatuses. Among these requirements there are the stability of the nominal frequency with temperature and the ageing and the low phase noise. Solid state oscillators are largely used as reference oscillators, especially if electronically tuneable like the VCXOs (Voltage Controlled Crystal Oscillators). Commercial TCXOs (Temperature Compensated Crystal Oscillators) and DRO (Dielectric Resonator Oscillators) are example of low cost tuneable solid state microwave oscillators; the latter with low phase noise and stable nominal frequency but only tuneable on a limited frequency range. The most sophisticated reference oscillators are nowadays embodied as true frequency synthesis networks, often employing more PLL (Phase-Locked Loop) arranged in nested loops, with mixers and frequency dividers (i.e.: presettable digital counters) in order to change the local frequency with fine steps. In the majority of the practical cases all the timing signals used in a communication apparatus are locked to a master oscillator. A sophisticated oscillator of this type is used, for example, inside the cellular hand-held telephones for the initial cell search by means of a large frequency scan. As well known, phase noise enlarges the spectral line of the reference frequency into a more or less wide frequency spectrum at the two sides of the reference. An excessive phase noise power density is a serious drawback, for example, in the communication apparatuses because by modulating a reference signal failing to fulfil with low phase noise requirements, the spectrum of the modulated signal is affected with excessive phase noise. The same drawback happens if the dirty reference signal is used to demodulate a reception signal. In general, the harmful effects of phase noise are experimented in all the operations involving frequency up-conversion because the phase, and so as phase noise, is multiplied by the up-conversion factor. In conclusion, those signals derived from poor phase-noise oscillators are unavoidably corrupted in an unpredictable way and the quality of the signal detected at the end of the transmission chain is negatively affected. Harmful effects on the quality are mainly due to the lowering of the S/N ratio and the increase of BER (Bit Error Rate) in case of data transmissions. Furthermore, even if the reference oscillator is low-noise, cleaning out the signal from residual phase noise is always recommendable to cope with severe specifications, especially in the field of telecommunications.

French patent N° 7910806, filed in the name of CIT-ALCATEL, on 27 April 1979, discloses a phase noise compensation circuit for a synchronous data transmission system having in reception a decision circuit which provides an estimate of the emitted symbols and a complex auto-adaptive long linear equaliser placed on the path of the signal received before the decision circuit, ensuring the correction of the amplitude and group delay linear distortions due to the transmission channel, characterised in that includes a complex auto-adaptive phase shifter equipped with a phase enslavement of the second order at least. The phase noise compensation circuit of this citation is too complicated and limited to the only reception, this because it exploits feedback hard decisions of a baseband equaliser whose it is part. Besides, the phase noise compensation circuit is only relevant to a numerical transmission system whose symbols belong to a known constellation.

### OBJECTS OF THE INVENTION

The main object of the present invention is that to overcome the limitations of the prior art and indicate a circuitry for neutralising (compensating) the harmful effects of phase noise of the reference oscillators included in electronic apparatuses operating with bandpass modulated signal, without any bond to a specific modulation, to the transmission media, or apparatus, although communication apparatuses are mostly involved.

### SUMMARY AND ADVANTAGES OF THE INVENTION

To achieve said object, the present application relates to a phase noise compensation circuitry for a reference oscillator, as disclosed in the claims. The phase noise compensation circuitry of the invention may be embodied either in analog or digital form, although the digital form is preferable for both digital and analog modulations/demodulations. The phase noise compensation circuitry of the invention is not subjected to the transmission media, which might be either free space or physical bearers. The digital embodiment is simple to manufacturing and low-cost because only standard components are used. The compensation circuitry is unchanged either in the transmitter and the receiver, saving production costs. Advantageously, a dedicated DSP together with an external look-up table for storing phase noise compensating values might implement all digital blocks relevant to the compensation circuit. Digital values stored in the look-up table are calculated scaling out the estimated phase noise opportunely, in this way the $2\pi$ cyclicity of phase noise is matched with the overflow of the digital signal representing the phase noise estimate, avoiding a dedicated management of the overflow, consequently. Digital values stored in the look-up table can be further calculated either to match the case of direct conversion from baseband to RF, or vice versa, or the most common case in which a preliminary intermediate frequency conversion is performed. The phase noise compensation circuit works in baseband but, differently from the cited French patent, doesn't require any knowledge about the type of modulation.

**BRIEF DESCRIPTION OF THE DRAWINGS**

The features of the present invention which are considered to be novel are set forth with particularity in the appended claims. The invention, together with further objects and advantages thereof, may be understood with reference to the following detailed description of an embodiment thereof taken in conjunction with the accompanying drawings given for purely non-limiting explanatory purposes and wherein:

- **fig.1** shows a simplified communication system including the phase noise compensation circuit of the present invention, embodied in analog form, included in an transmitter and a receiver suitable for analog modulations;
- **fig.2** shows a simplified transmitter suitable for digital modulations including the phase noise compensation circuit of the present invention embodied in digital preferred form;
- **Figures 3** and **4** show a partial representation of a transmitter suitable for analog modulations including the phase noise compensation circuit of the present invention embodied in digital form;
- **Figures 5** and **6** show the spectral comparison between uncompensated and compensated phase noise; and
- **fig.7** shows a preferred embodiment of the transmitter of fig.2 suitable for frequency conversion with phase noise division.

**DETAILED DESCRIPTION OF AN EMBODIMENT OF THE INVENTION**

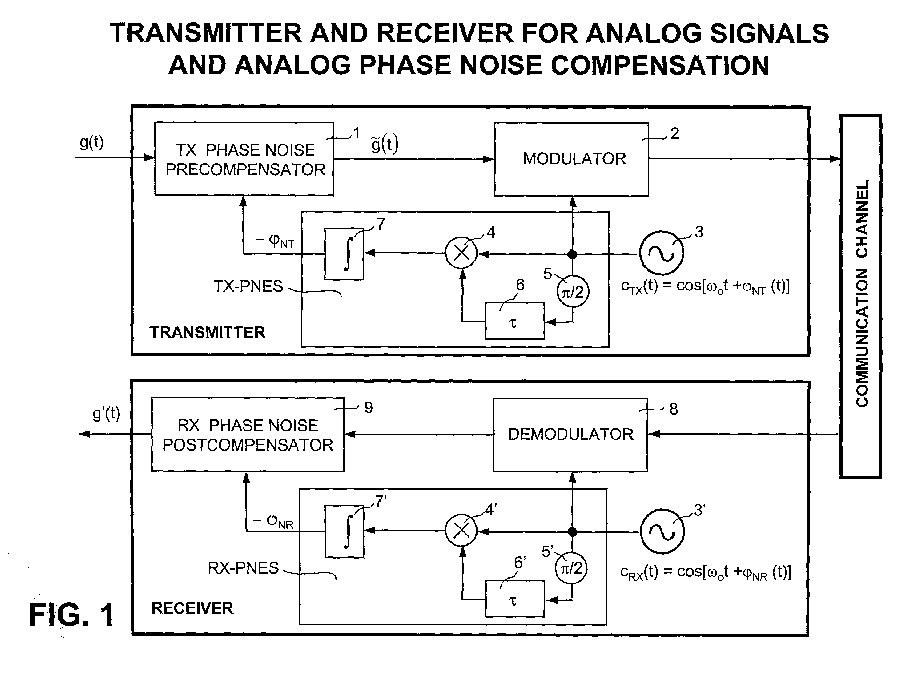

**Fig.1** shows a general purpose communication system including a transmitter and a receiver connected to each other through a communication channel. One-way transmission only is depicted, but the same embodiment of the invention is usable on the other transmission direction of a two-way channel, in accordance with the implemented duplexing mode. As far as the communication channel is concerned all known transmission media can be used: i.e. radio, cable, fibre, etc., on condition that a bandpass signal obtained by means of a reference oscillator (unavoidably affected by phase noise) is transmitted. In an extreme case a pure reference tone could be frequency translated and transmitted. With reference to **fig.1** the transmitter includes three main interconnected blocks named: TX PHASE NOISE PRECOMPENSATOR 1, MODULATOR 2, and TX-PNES; for the sake of simplicity other traditional elements, such as filters, amplifiers, etc. are not represented. Block 1 receives from a baseband unit (not shown) a baseband modulating signal $g(t)$ and from TX-PNES a phase noise compensating signal $-\varphi_{NT}(t)$ and outputs a phase noise precompensated signal $\tilde{g}(t)$ towards the input of block 2. The latter also receives a sinusoidal signal $c_{TX}(t)=cos[\omega_o t + \varphi_{NT}(t)]$ generated by a reference oscillator 3 and outputs towards the communication channel an radiofrequency modulated signal having a bandpass spectrum allocated around (or at one side of) the reference oscillator frequency $f_o = \omega_o/2\pi$ (in reality an intermediate frequency conversion comes before). Phase noise of the oscillator 3 is represented by the term $\varphi_{NT}(t)$. The reference oscillator signal $c_{TX}(t)$ also feeds the block TX-PNES for the generation of the correction term $-\varphi_{NT}(t)$ which summing up with $\varphi_{NT}(t)$ cancels the latter. Inside the block TX-PNES signal $c_{TX}(t)$ is applied to a first input of a mixer 4, directly, and to the other input of the same mixer by means of a $\pi/2$ phase shifter 5 and a downstream delay line 6 that introduces a fixed time delay $\tau$ on the phase shifted signal. The delay $\tau$ is equal to a multiple $N$ of the period $T_o$ of the reference oscillator signal $c_{TX}(t)$, namely: $\tau = NT_o = \frac{N}{f_o}$. The output of mixer 4 is connected to an integrator 7 which outputs the phase noise compensating signal $-\varphi_{NT}$ directed to the phase noise precompensator 1.

The receiver includes three main interconnected blocks named: DEMODULATOR 8, RX PHASE NOISE POSTCOMPENSATOR 9, and RX-PNES; other traditional elements, such as filters, amplifiers, etc. are not represented for simplicity. Block 8 is connected to the channel for receiving the RF modulated signal and to a reference oscillator 3' generating a sinusoidal signal $c_{RX}(t)=cos[\omega_o t+\varphi_{NR}(t)]$ affected by phase noise $\varphi_{NR}(t)$. The demodulator 8 outputs towards block 9 a demodulated signal affected by the same phase noise as the reference oscillator. Block 9 also receives a compensating signal $-\varphi_{NR}$ from RX-PNES and returns a baseband signal $g'(t)$ substantially cleaned from the oscillator phase noise. The reference oscillator signal $c_{RX}(t)$ also feeds the block RX-PNES for the generation of the compensation term $-\varphi_{NR}$. Inside the block RX-PNES the signal $c_{RX}(t)$ is applied to a circuitry whose elements 4', 5', 6', and 7' are similar to the 4, 5, 6, and 7 of the transmitter.

Precompensation is possible with any type of modulation, either analog or digital. A preferred embodiment of the invention detailed for digital modulations will be described later on, while in the following a more general approach of the invention valid for analog modulation is considered. Without limitation the following analog modulations are examined: Amplitude Modulation (AM), Phase Modulation (PM), and Frequency Modulated (FM). Remembering the Eulero's relation $e^{jx} = cos\ x + jsinx$, the Double-Sideband Suppressed Carrie (DSBSC) amplitude modulation has the general expression: $m(t) = Re_{\llcorner}\ m_a g(t) \cdot e^{j2\pi f_o t}{}_{\lrcorner}$ where $m_a$ called the AM modulation index is the ratio of the peak amplitude of the modulating signal to the amplitude of the carrier. A particular AM case is the Single Sideband (SSB) modulation, which may be in theory derived by passing a double sideband modulated wave through an ideal filter having the infinite step high-pass / low-pass characteristic. In such a case the SSB modulated wave has the expression: $m(t)_{SSB} = Re_{\llcorner}\ m_a(g(t) \pm j\hat{g}(t)) \cdot e^{j2\pi f_o t}{}_{\lrcorner}$, where $\hat{g}(t)$ is the Hilbert transform of $g(t)$. Both PM and FM are angular modulations given by the common expression: $m(t) = Re_{\llcorner}\ e^{j\phi} \cdot e^{j2\pi f o t}{}_{\lrcorner}$, where $\phi$ is the phase. A Phase Modulated (PM) wave has the expression: $m(t) = Re_{\llcorner}\ e^{jm_p g(t)} \cdot e^{j2\pi f_o t}{}_{\lrcorner}$, where $m_p$ is the PM modulation index expressed in rad/V, also commonly termed the peak phase deviation. A Frequency Modulated (FM) wave has the expression:

$$m(t) = Re\left[ e^{j\int_0^t [m_f g(\tau) d\tau]} \cdot e^{j2\pi f_o t} \right]$$

where $m_f$ is the peak frequency deviation expressed in rad/(V.s). Frequency modulation can be performed as a phase modulation on condition that an integrator circuit is placed upstream the modulating signal $m_f g(t)$ and a derivator circuit is placed downstream the demodulated signal. Phase noise of the oscillator 3 is considered in the AM, PM, and FM expressions by introducing the noise term $e^{j\varphi(t)_{NT}}$ into the brackets of $Re[\cdots]$. This is equivalent to multiply the first term in brackets by $e^{j(2\pi f_o t + \varphi(t)_{NT})}$. The noise term is cancelled by introducing the estimated correction term $e^{-j\varphi_{NT}}$ into the brackets. Remembering that each narrowband bandpass signal (such as the modulated signals presently considered) can be completely described by its complex envelope in baseband, and that $cos(-\varphi_{NT}) = cos(\varphi_{NT})$, $sin(-\varphi_{NT}) = -sin(\varphi_{NT})$, the following general expression is valid for the baseband precompensated term $\tilde{g}(t)$ :

$$\tilde{g}(t) = \left\{ \tilde{g}_I ;\ \tilde{g}_Q \right\} = \left\{ MC \cdot cos\varphi_{NT} ;\ MC \cdot sin\varphi_{NT} \right\},$$

where: $MC$ is in turn the following modulation component: $m_a g(t)$ for AM; $m_p g(t)$ for PM; and

$$\int_0^t m_f g(\tau) d\tau$$

for FM.

The implementation of the TX PHASE NOISE PRECOMPENSATOR 1 in analog fashion is quite a difficult task, mainly because of the difficult to obtain in analog way the sine and cosine functions of analog arguments, nevertheless it is possible. For example a way is offered by the Multi-Function Converter integrated circuit LH0094 of the National Semiconductor suitable for input signals not excessively fast. This circuit together with a cascaded operational amplifier generates analog output voltages that are either the sine or the cosine of the input voltage depending on the values of some external resistors. Each multiplication of the $MC$ by $cos(\varphi_{NT})$ and $sin(\varphi_{NT})$ can be performed by using an operational amplifier having the two-input adder configuration to summing up the voltages at the output of two logarithmic amplifiers, whose inputs are the respective multiplicand terms. Two antilog amplifiers return to the natural value the logarithmic voltages $\{\tilde{g}_I ; \tilde{g}_Q\}$ at the output of the respective adder amplifiers.

The aim of the TX-PNES block is that to obtain a real time estimation of the phase noise term $\varphi_{NT}(t)$ in order to obtain the couple of correction values $cos\varphi_{NT}$, $sin\varphi_{NT}$. The spectrum of the precompensated signal $\tilde{g}(t)$ is momentarily worsen by the quadrature modulation with the phase noise estimated term $\varphi_{NT}(t)$, but at the successive interaction (multiplication) with the noisy local oscillation $c_{TX}(t)$ the original shape of the $g(t)$ spectrum is restored (by effect of phase noise contribution) just when the modulation is impressed on the local oscillation $c_{TX}(t)$.

Considering now the operation of block TX-PNES, at the output of phase shifter 5 a signal $sin[2\pi f_o t + \varphi_{NT}(t)]$ is present, while at the output of the delay line 6 there is $sin[2\pi f_o(t-\tau) + \varphi_{NT}(t-\tau)]$. At the output of the multiplier 4 there is:

$$cos[2\pi f_o t + \varphi_{NT}(t)] \cdot sin[2\pi f_o(t-\tau) + \varphi_{NT}(t-\tau)] =$$

$$cos[2\pi f_o t + \varphi_{NT}(t)] \cdot sin[2\pi f_o(t) + \varphi_{NT}(t-\tau)] =$$

$$\tfrac{1}{2}\{sin[4\pi f_o t + \varphi_{NT}(t) + \varphi_{NT}(t-\tau)] - sin[\varphi_{NT}(t) - \varphi_{NT}(t-\tau)]\}.$$

The integrator 7 filters out the first component at the frequency $4\pi f_o$ and integrates the second component. Considering the linearity of the function $sin(x)$ for low values of its argument [x], an opportune choice of the time delay $\tau$ might allow the following noticeable simplification:

$$sin[\varphi_{NT}(t) - \varphi_{NT}(t-\tau)] \cong \varphi_{NT}(t) - \varphi_{NT}(t-\tau),$$

and the following approximation is valid:

$$-\varphi_d = -\varphi_{NT}(t) - \varphi_{NT}(t-\tau) = -\tau \cdot \frac{\varphi_{NT}(t) - \varphi_{NT}(t-\tau)}{\tau} \approx -\tau \cdot \frac{d\varphi_{NT}(t)}{dt}.$$

A possible $\tau$ value enabling the above simplification is one by which $|\varphi_{NT}(t-\tau) - \varphi_{NT}(t)|$ is lower than 10-15% of $\varphi_{NT}(t)$. The aim of the successive arguments is that to demonstrate the possibility of said approximation. Considering $\varphi_{NT}(t)$ as a cyclostationary random process, its autocorrelation function is only function of $\tau$ and the imposed restriction on the argument of the sine function indicates a well correlated noise process. Because of the spectral power density of a stationary random process is definable as the Fourier transform of the autocorrelation function, dual effects of the aforementioned imposed restriction are involved in the frequency domain. Logarithm of the Phase noise spectral power density has a linear trend with the logarithm offset $\Delta f$ from $f_o$, as disclosed in the article titled: "Oscillator Phase Noise: A Tutorial", author Thomas H. Lee, published on IEEE JOURNAL OF SOLID STATE CIRCUITS, VOL. 35, No. 3, March 2000, which constitutes an interesting background on this matter. From the article it results to be usual normalise the mean-square voltage of the noise spectral density (single-sideband) to the mean-square voltage of the carrier and report the ratio in decibels. These units are thus proportional to the log of a spectral power density. Specifically, they are commonly expressed as "decibels below the carrier per Hertz", or dBc/Hz, referable to particular offset $\Delta f$ from the carrier frequency $f_o$. Plots of phase noise power density versus frequency linearly decrease 20 dB per decade of $\Delta f$. Values $\leq$ -100 dBc/Hz at 1 kHz from the carrier have to be considered as very good performances for the oscillators. Due to the rapid variation of the power density function, the most significant phase noise variations are narrowband around $f_o$ and a small $\Delta f$ is concerned (few kHz). From the above consideration about the conjugation between autocorrelation and Fourier transform of the power density, it descends that offset $\Delta f$ can also be expressed in terms of $1/\tau$ and small $\Delta f$ also means large delay $\tau$. A large delay $\tau$ is considerably greater than the time constant given by the reciprocal bandwidth $(1/G(f)_{3dB})$ of the modulating signal $g(t)$ and the starting restrictive hypothesis are largely fulfilled Because the unique non-ideality that could cause an imperfect phase noise cancellation is due to the delay $\tau$, the effectiveness of the phase noise cancellation performed by the TX-PNES circuitry is not at all compromised in consequence of the slow time variation of the phase noise process in comparison with the baseband signal.

The integrator 7 is typically an RC network having a time constant $\tau_c = 1/RC \approx \tau$ which continuously performs:

$$-\int_t^{t+\tau} \varphi_d \, dt = -\tau \cdot \int_t^{t+\tau} \left( \frac{d\varphi_{NT}(t)}{dt} \right) dt = -\tau \cdot \varphi_{NT} \, .$$

. The output voltage of the integrator 7 is proportional, through the constant $\tau$, to the difference between the phase noise voltage across the delay $\tau$. This output voltage has to be scaled out in order to obtain the right correction voltage $-\varphi_{NT}$ used by the TX PHASE NOISE PRECOMPENSATOR 1 to calculate $\widetilde{g}(t)$.

The aim of the RX-PNES block of the receiver is the same as TX-PNES of the transmitter and the two blocks are in fact identical. The only difference between the transmitter and the receiver is that the first cancels in advance the phase noise before modulation (precompensation), while the second cancels the phase after demodulation (postcompensation). Because of the operations concerning phase noise compensation performed by the demodulator 8 are dual of those of modulator 2, the preceding description of the transmitter is also valid for the receiver and the detailed description of the latter is superfluous.

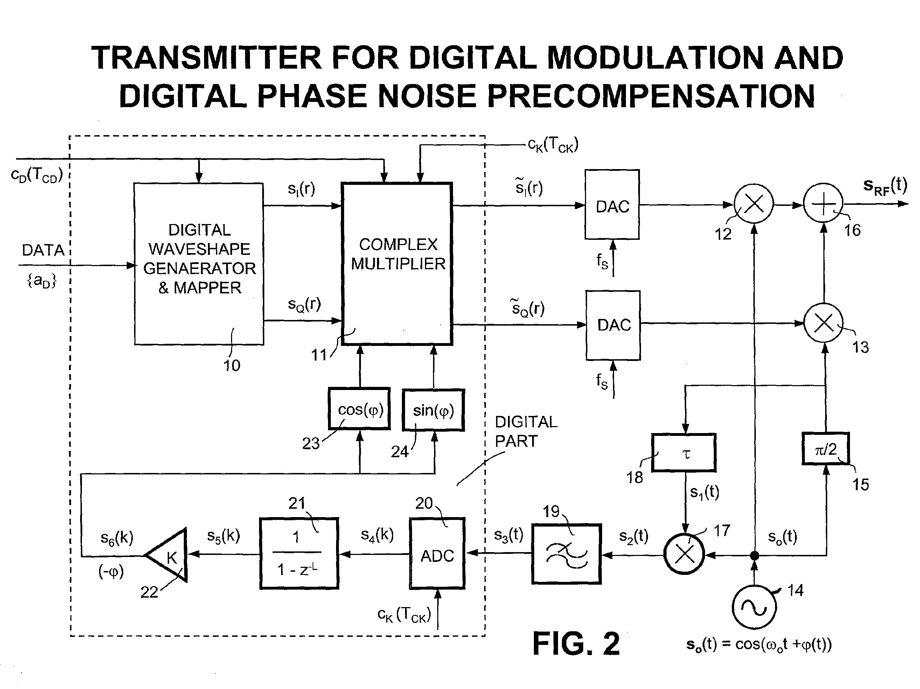

**Fig.2** shows a digital transmitter, to say, one suitable to transmit digitally modulated signals, which includes a phase noise precompensation circuit constituting a preferred embodiment of the present invention (marked blocks). For the sake of simplicity traditional elements, such as filters, amplifiers, etc. are not represented. Without limitation, the transmitter is usable in the telecommunication apparatuses manufactured by the Assignee of the present invention, i.e.: on-sight high/medium/low capacity radio links, cellular telephone systems, satellite earth stations, cable transmissions, analog optical links, etc.

With reference to **fig.2**, the transmitter includes a block 10 named DIGITAL WAVESHAPE GENERATOR & MAPPER that receives digital DATA belonging to an information sequence $\{a_D\}$, (either computer data, or numeric voice, sound, television, etc.) and a digital clock $c_D(T_{CD})$ with frequency $f_{CD} = 1/T_{CD}$, and outputs at each discrete interval $T_S = rT_{CD} = r/f_D$, with $r$ integer, a couple of digital samples $s_I(r)$, $s_Q(r)$ called the In-Phase (I) and In-Quadrature (Q) components of the modulating digital signal, respectively. The two digital I-Q components reach the input of a COMPLEX MULTIPLIER 11 which also receives the following digital signals: the clock $c_D(T_{CD})$ associated to the input data, two digital signals $sin(\varphi)$ and $cos(\varphi)$ from the phase noise estimation part, another clock $c_K(T_{CK})$ associated to the preceding signals of the estimation part and outputs at the symbol frequency $f_S = f_D/r$ two compensated components $\tilde{s}_I(r)$, $\tilde{s}_Q(r)$ towards two respective Digital-to-Analog converters clocked at symbol frequency $f_S$. The two $\tilde{s}_I(r)$ and $\tilde{s}_Q(r)$ components, after analog conversion, reach first inputs of two respective mixers 12 and 13. A reference oscillator 14 generates a sinusoidal signal $s_o(t) = cos[\omega_o t + \varphi(t)]$, where $\varphi(t)$ is the phase noise contribution, and forwards it to the mixer 12, directly, and to a $\pi/2$ phase shifter 15 whose shifted signal is forwarded to the other mixer 13. The outputs of the two mixers 12 and 13 are summed up by an analog adder 16, obtaining a digitally modulated radiofrequency signal $s_{RF}(t)$ to be amplified and transmitted (the IF conversion is at present not indicated). The reference oscillator signal $s_o(t)$ is also sent to a first input of another mixer 17, whose second input receives a signal $s_1(t)$ outputted by a delay line 18 that introduces a fixed delay $\tau$ on the signal at the output of the phase shifter 15. The delay $\tau$ is equal to a multiple $N$ of the period $T_o$ of the reference oscillator signal $s_o(t)$, namely: $\tau = NT_o = \frac{N}{f}$. The baseband signal $s_2(t)$ at the output of the mixer 17 crosses a low-pass filter 19 and the filtered signal $s_3(t)$ is sent to an Analog-to-Digital converter 20, which receives the clock $c_K(T_{CK})$ and outputs with cadence $T_{CK}$ as many digital samples $s_4(k)$. These samples reach a pseudo-integrator block 21 that outputs a signal $s_5(k)$ towards a digital multiplier 22 by a constant factor K, obtaining a signal $s_6(k) = -\varphi$. The latter is sent to two look-up tables 23 and 24 where acts as an address for obtaining in correspondence a digital sample of the respective functions $sin(\varphi)$ and $cos(\varphi)$. These digital samples are sent to the complex multiplier 11 which carries out the following digital products: $\tilde{s}_I(r) = [s_I(r) \cdot cos\varphi]$ and $\tilde{s}_Q(r) = \lfloor s_Q(r) \cdot sin\varphi \rfloor$ in order to perform a digital precompensation of the reference oscillator phase noise.

In operation, block 10 performs a mapping function by taking blocks of $r = log_2 M$ binary digits at a time from the information sequence $\{a_D\}$ constituting the DATA input and selects one out of $M = 2^r$ blocks to obtain at the output of the adder 16 a corresponding deterministic, finite energy waveform $s_{RF}(t) = \{s_m(t), m=1,2,...,M\}$ for transmission over the channel. Mathematical expressions of the waveforms $\{s_m(t)\}$ are achievable assigning discrete values to: the amplitude (PAM), the phase (M-PSK), or both the amplitude and the phase (M-QAM) of the modulating signal. The baseband part of those expressions constitute the In-Phase and In-Quadrature digital components at the output of block 10 (in case of PAM the only In-Phase component is obtained). For M-PSK modulation the signal waveforms $\{s_m(t)\}$ are expressed as:

$$s_m(t) = Re\left[g(t)e^{j2\pi(m-1)/M} \cdot e^{j2f_o t}\right], \qquad m = 1,2,...,M, \qquad 0 \le t \le T$$

$$= g(t)cos\left[2\pi f_o t + \frac{2\pi}{M}(m-1)\right]$$

$$= g(t)cos\frac{2\pi}{M}(m-1)cos\,2\pi f_o t \; - \; g(t)sin\frac{2\pi}{M}(m-1)sin\,2\pi f_o t$$

where $g(t)$ is the signal pulse shape, and $\theta_m = 2\pi(m-1)/M$, $m=1,2,...,M$ are the $M$ possible phases of the carrier that convey the transmitted information. A digital Root Raised Cosine (RRC) filter with opportune roll-off is usually taken for $g(t)$. From the above expression it descends that for M-PSK: $s_I(r) = g(r)cos\theta_m$ and $s_Q(r) = g(r)sin\theta_m$ are the baseband I-Q components of digital symbols.

To improve the spectral gain of the M-PSK modulation both the amplitude and the phase of the waveforms $s_m(t)$ can be changed simultaneously, obtaining an M-QAM modulation. The M-QAM modulation is obtained by impressing two separate n-bit symbols from the information sequence $\{a_n\}$ on two quadrature carriers $cos\,2\pi f_o t$ and $sin2\pi f_o t$. The corresponding signal waveforms may be expressed as:

$$s_m(t) = Re\left[\left(A_{mc} + jA_{ms}\right)g(t)\cdot e^{j2f_o t}\right], \qquad m = 1,2,\ldots,M, \qquad 0 \le t \le T$$
$$= A_{mc}g(t)\cos 2\pi f_o t \ - \ A_{ms}g(t)\sin 2\pi f_o t$$
$$= V_m g(t)\cos\left(2\pi f_o t + \theta_m\right)$$

where: $A_{mc}$ and $A_{ms}$ are the information-bearing signal amplitudes of the quadrature carriers; $V_m = \sqrt{A_{mc}^2 + A_{ms}^2}$ and $\theta_m = tan^{-1}(A_{ms}/A_{mc})$. From the above expression for M-QAM it descends that: $s_I(r)=V_m g(r)cos\theta_m$ and $s_Q(r)=V_m g(r)sin\theta_m$ are the baseband I-Q components of digital symbols.

As far as the phase noise estimation is concerned, at the output of the delay line 18 there is the signal $s_1(t)$ = $A\ sin[2\pi f_o(t-\tau)+\varphi(t-\tau)]$. The output signal of the multiplier 17 is $s_2(t)=A^2 Gs_o(t)\cdot s_1(t)$, where $G$ is a scale factor forcing the output to assume the same value as the inputs ($G$ is $V^{-1}$ dimensioned). Before the signal $s_2(t)$ is analog-to-digital converted, it must be passed trough the anti-alias filter 19. The most significant phase noise components fall inside the band of $f_{CK}/2$, in consequence of that the following ideal Low Pass Function is selected for the anti-alias filter 19:

$$H(f) = H \qquad for |f| \le f_{CK}$$

$$H(f) = 0 \qquad for\ |f| > f_{CK}$$

This function is approximated by a real filter having at least a pole at the frequency $f_{CK}$. An active low-pass filter has the advantage to freely set the gain $H$ .
At the output of filter 19 there is:

$$s_3(t) = A^2 GH\ sin[\varphi(t-\tau)-\varphi(t)] \approx - A^2 GH(\varphi(t)-\varphi(t-\tau)).$$

Let $Q$ be the number of bits of the ADC converter 20 and $V_{FS}$ the maximum voltage range admitted at the input, at the output of the ADC there is the following digital signal $s_4(k) = -A^2 GH\cdot 2^Q/V_{FS}(\varphi(kT_{CK})-\varphi(kT_{CK}-\tau)) = -B(\varphi(kT_{CK})-\varphi(kT_{CK}-\tau))$, where $B = A^2 GH\cdot 2^Q/V_{FS}$. In the domain of the Z-transform it results: $S_4(z)=\dfrac{-B\Phi(z)}{1-z^{-L}}$, where $\Phi(z)$ is the Z-transform of $\varphi(kT_{CK})$ and $L$ indicates how many time the delay $\tau$ is multiple of the period $T_{CK}$, namely: $L=\dfrac{\tau}{T_{CK}}$. The aim of block 21 is to recovery the operation of derivation implicitly performed when the in-phase carrier is multiplied by the delayed in-quadrature carrier, as already said with regard to the fig.1. A transfer function of the $\dfrac{1}{1-z^{-L}}$ type is suitable to this purpose; in fact it results:

$$S_5(z) = \left(\frac{1}{1-z^{-L}}\right)S_4(z) = -B\,\Phi(z)\,.$$

The inverse Z-transform of $S_5(z)$ has the following expression:
$s_5(k) = s_4(k)+s_5(kT_{CK}-L) = -B\varphi(k)$. The aim of block 22 is that to scale out the multiplier term $B$ in order to have $s_6(k) = -\varphi(k)$. Because of $s_6(k) = -K\ B\varphi(k)$ it results: $K = 1/B = V_{FS}/(A^2\cdot G\cdot H\cdot 2^Q)$. In practice block 22, so as the $1/B$ division, may be implicitly included in the pairs of look-up tables 23 and 24. These tables store digital samples of $cos\varphi$ and $sins\varphi$, respectively, calculated in a way that the $2\pi$ cyclicity of phase noise $\varphi$ is forced to correspond to the overflow of the digital signal $s_5(k)$, avoiding a dedicated management of the overflow at the output of the pseudo-integrator 21. The above condition is the following:

$$s_5(k) = 2^{Q-1} \rightarrow \varphi = -\pi$$

$$s_5(k)=-2^{Q-1} \rightarrow \varphi = \pi$$

This implies a well determined choice of B, in fact:

$$2^{Q-1} = \sim B(-\pi) = \frac{\pi(A^2 \cdot G \cdot H \cdot 2^Q)}{V_{FS}} \rightarrow \frac{A^2 \cdot G \cdot H}{V_{FS}} = \frac{1}{2\pi}$$

The last expression introduces some restrictions on the value of the parameters $G$, $V_{FS}$, and $H$. In general, $G$ and $V_{FS}$ are characteristics parameters of the selected components, while H may be freely chosen from the designer. Numeric value of the parameter $L$ shall be determined considering that the delay $\tau$, besides to be expressed as $L \cdot T_{CK}$, has also to be expressed as $N \cdot T_o$. The following equalities hold: $\frac{N}{L} = \frac{T_{CK}}{T_o} = \frac{f_o}{f_{CK}}$, being $f_o > f_{CK}$ and $N > L$. The lower limit of $N$ is given by the fact that in $S_5(z)$ must be $L \geq 1$, which entails: $N f_{CK}/f_o \geq 1 \rightarrow N \geq f_o/f_{CK}$. Taking $L>1$, which implies $N>f_o/f_{CK}$, the delay $\tau$ increases so as the power of the analog signal $s_3(t)$ at the input of the ADC 20, this because the power of additional lower frequency components of phase noise enters. This involves an increase of the ratio between phase noise and quantization noise, nonetheless the selection of $L=1$ is advisable because with $\tau=T_{CK}$ the captured phase noise is enough and a wider noise band can be compensated, besides block 21 becomes a true numeric integrator easier to be realised. The selection of $L=1$ entails $N=\frac{f_o}{f_{CK}}$. A further simplification is that to put $T_{CD}=T_{CK}$, so as a sole external digital clock is used by the transmitter.

Digital receiver is achievable from the transmitter of fig.2 by inverting the arrows in the upper part concerning the incoming $s_{RF}(t)$ signal and the demodulated I-Q components.
More precisely, the analog adder 16 shall be replaced with a splitter and the two DACs with ADCs, while the digital phase-noise compensation part remains the same. Generally speaking a digital receiver is much more complicated than the transmitter of fig.2, nevertheless, for the only aim of the reference oscillator phase noise compensation it behaves dual. The greater complication of the receiver is mainly due to the estimation of the variable propagation delay from the transmitter to the receiver; this is essential to a correct detection of the transmitted symbols. Besides, if the detector that generally follows the demodulator is coherent, the phase of the carrier must also be recovered. The received signal is unavoidably corrupted by noise which complicates the two estimations of above. The design of the detector is outside the scope of the present invention.

Digital transmitter of **fig.2** and the dual receiver are implemented by means of standard devices Advantageously a dedicated DSP together with the external look-up tables 23 and 24 can be used to implement all digital blocks relevant to the transmitter and the receiver.

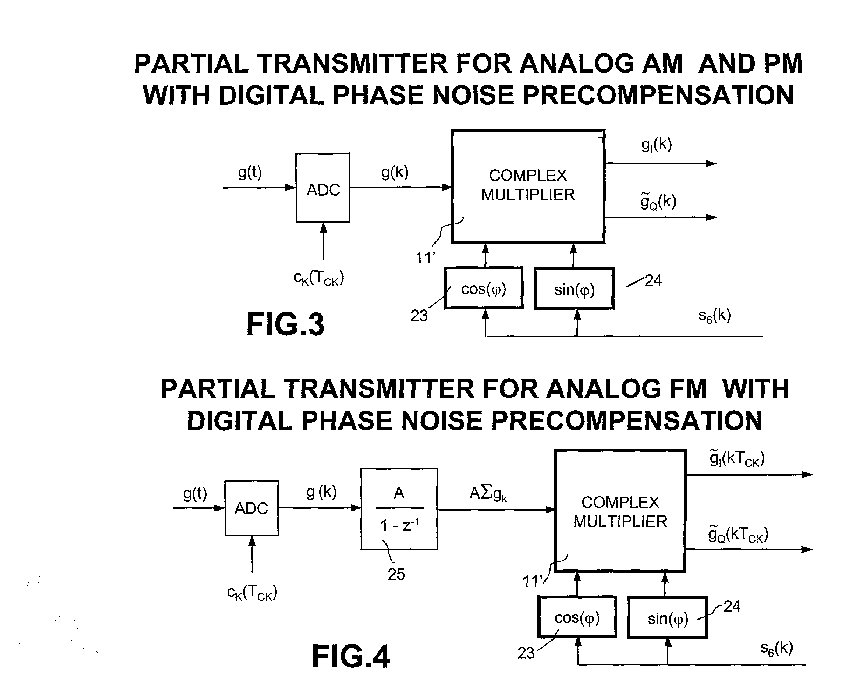

**Figures 3** and **4** demonstrate the capacity of the digital phase noise compensating circuit of **fig.2** to work correctly in conjunction with conventional analog modulations like AM, PM (fig.3) and FM (fig.4). The two Figures show the only input part of a transmitter slight different from the one of fig.2. In the depicted input part an Analog-to-Digital converter clocked by $c_K(T_{CK})$ digitally converts the analog modulating signal $g(t)$ and forwards $g(k)$ to a COMPLEX MULTIPLIER 11'. The latter is different from the similar block 11 (fig.2) mainly because it has one only input for the modulating signal and performs multiplications at $f_{CK}$ frequency rather than $f_s$. All the remaining blocks of fig.2 are unchanged. Double sideband Amplitude Modulation and Phase Modulation shown in **fig.3** don't require to be commented. With reference to **fig.4** valid for the FM modulation, a numeric integrator 25 is placed between the incoming ADC and the complex multiplier 11'. The numeric integrator 25 is represented by the Z-transform $\frac{A}{1-z^{-1}}$ of its transfer function, where $A=\tau \cdot m_f$ is a constant descending from the numerical integration of $m_f g(k)$.

Receivers dual to the transmitters of the **Figures 3** and **4** are promptly obtained by introducing the same indications valid for the dual receiver of the transmitter depicted in fig.2, with the difference that in this case the demodulated signals are obtained by summing up the two digital postcompensated I-Q components before sending the resulting signal to an outcoming digital-to-analog converter. Besides for the only FM receiver a numerical derivation shall be performed before the analog conversion.

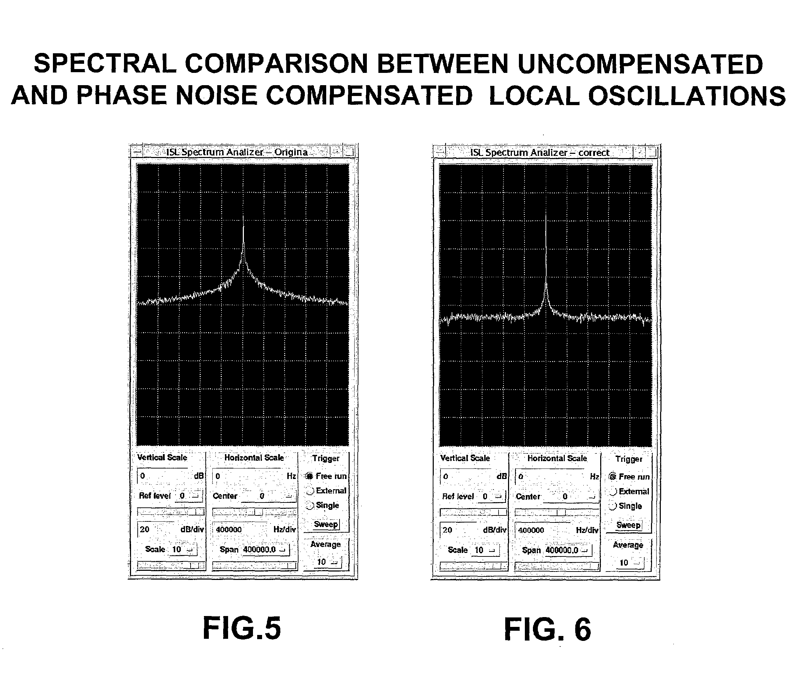

With reference to the **Figures 5** and **6**, the effectiveness of phase noise compensation circuit of the invention in subject has been checked directly on the screen of a spectrum analyser connected at the output of the digital transmitter of **fig.2**. **Fig.5** shows the case of compensation and **fig.6** of uncompensation. For this aim constant data (a string of all 1s) are transmitted, in order to appreciate the compensation effect on the $f_o$ line. The sound effect of compensation is evident from the comparison of the plots before and after phase noise compensation. The screen on the right shows an almost monochromatic line at $f_o$ where the compensated phase noise is near completely at floor level. Besides, the power at $f_o$ is considerably increased at the detriment of the noise in comparison with the uncompensated phase noise of the left screen (fig.6). The positive result suggests to us of using the reference oscillator 14 for generating the digital clock $c_K(T_{CK})$; the integer ratio $N$ existing between frequencies of the two signals make easier this task by using a common PLL.

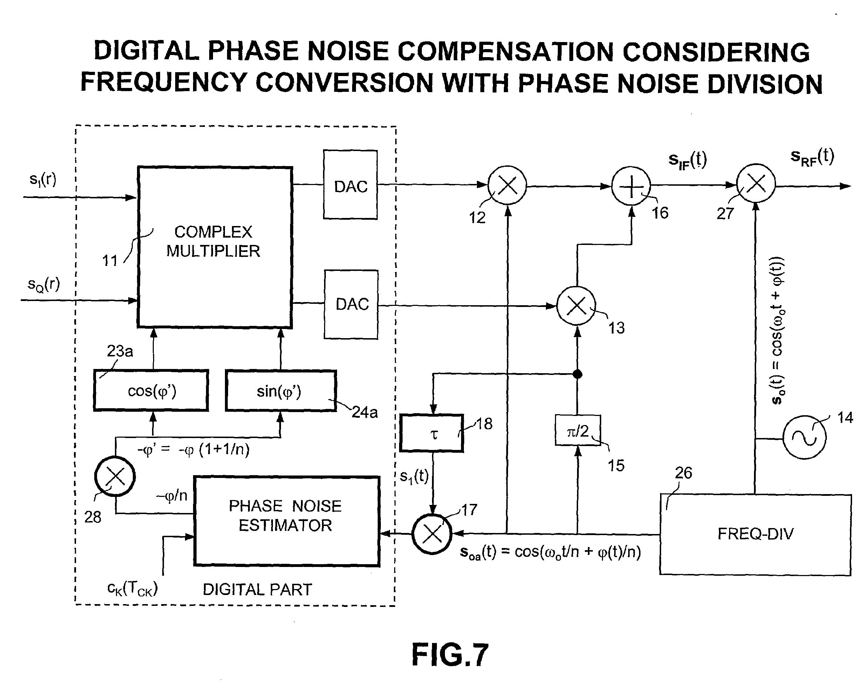

**Fig.7** shows a preferred embodiment of the digital transmitter which differs from the one of **fig.2** for the presence of a block FREQ-DIV 26, a further mixer 27, and a digital multiplier 28. Block 26 is a frequency synthesis network of known type which receives a high frequency reference oscillator signal $s_o(t)=cos(\omega_o t+\varphi(t))$ from the oscillator 14 and performs a frequency division by an integer $\underline{n}$, obtaining an intermediate frequency (IF) reference signal $s_{oa}(t)=cos(\omega_o t/n+\varphi(t)/n)$. Remembering the previous assumption of $L=1$ it results $n=N$. The IF reference signal $s_{oa}(t)$ is sent to the modulator part 12, 13, 15, 16 for obtaining an IF modulated signal $s_{IF}(t)$, and to the PHASE NOISE ESTIMATOR circuitry to obtain an estimation value $-\varphi/n$. The last is sent to the digital multiplier 28 which multiplies it by $(n+1)$ obtaining a value $-\varphi'=-\varphi((1/n)+1)$ forwarded to two modified look-up tables 23a and 24a, that store digital samples of the functions $cos(\varphi')$ and $sin(\varphi')$, respectively. The mixer 27 receives both the high frequency reference oscillator signal $s_o(t)$ and the precompensated IF modulated signal $s_{IF}(t)$ and outputs the radiofrequency signal $s_{RF}(t)$ cleaned from phase noise. The reference oscillator 14 is similar to the classical local oscillator of the superheterodyne radio. In operation, it must be considered that both the frequency and phase noise spectral density are divided by $\underline{n}$ in consequence of a frequency division by $\underline{n}$, and thus a multiple phase noise compensation is needed. This task is performed digitally by the modified look-up tables 23a and 24a, while the COMPLEX MULTIPLIER 11 is unchanged. The receiver is dual.

## Claims

1. A phase noise compensation circuitry connectible to a reference oscillator generating a reference signal ($c_{TX}(t)$, $c_{RX}(t)$, $s_o(t)$) affected by phase noise, exploitable either for modulation, demodulation, or simply frequency conversion, **characterised in that** includes:

   - phase shifting means (5, 5', 15) for $\pi/2$ phase shifting the reference signal;
   - time delaying means (6, 6', 18) coupled downstream the phase shifting means (5, 5',15) for introducing a fixed delay $\tau$ on the $\pi/2$ phase-shifted reference signal;
   - first multiplying means (4, 4', 17) for multiplying the reference signal by its shifted and delayed copy ($s_1(t)$), obtaining a baseband voltage ($s_2(t)$ proportional to the time derivative of the phase noise voltage generated by the reference oscillator (3, 3', 14);
   - integrating means (7, 7', 21) for integrating during said fixed delay $\tau$ the signal at the output of said first multiplying means, obtaining an estimation voltage ($-\varphi_{NT}$, $-\varphi_{NR}$, $-\varphi$) proportional to the difference between the phase noise voltage across the fixed delay ($\tau$);
   - means (1, 9, 22, 23, 24) for generating phase noise compensation factors in quadrature to each other corresponding to sine and cosine values of said phase noise estimation voltage ($-\varphi_{NT}$, $-\varphi_{NR}$, $-\varphi$);
   - second multiplying means (1, 9, 11) for multiplying the sine and cosine values by modulating/demodulated signal components, obtaining either a phase-noise precompensated modulating signal ($\tilde{g}(t)$, $\tilde{s}_I(r)$, $\tilde{s}_Q(r)$) or a postcompensated demodulated signal ($g'(t)$).

2. The phase noise compensation circuitry of the claim 1, **characterised in that** the reference oscillator (3, 14) belongs to a transmitter including:

   - means (26) for frequency dividing the reference signal ($c_{TX}(t)$, $s_o(t)$) by an integer $\underline{n}$ obtaining an intermediate frequency reference signal ($s_{oa}(t)$) supplied to a modulator (2, 12, 13, 16) which also receives said precompensated modulating signal ($\tilde{g}(t)$, $\tilde{s}_I(r)$, $\tilde{s}_Q(r)$); being the intermediate frequency reference signal ($s_{oa}(t)$) further supplied to said phase shifting means (5, 15) and first multiplying means (4, 17) obtaining a submultiple estimation voltage ($-\varphi/n$) at the output of said integrating means (7, 7', 21);
   - means (26) for multiplying by ($n+1$) the submultiple estimation voltage ($-\varphi/n$);
   - means (27) for frequency multiplying an intermediate frequency signal ($s_{IF}(t)$) at the output of the modulator (12, 13, 16) by the integer $\underline{n}$, obtaining a radiofrequency transmission signal ($s_{RF}(t)$) cleaned from phase noise.

3. The phase noise compensation circuitry of the claim 1, **characterised in that** the reference oscillator (3, 14) belongs to a receiver including:

- means (27) for frequency down converting by an integer $\underline{n}$ the received signal ($s_{RF}(t)$) obtaining an intermediate frequency signal ($s_{IF}(t)$);
- means (26) for frequency dividing the reference signal ($s_o(t)$ ) by the same integer $\underline{n}$ obtaining an intermediate frequency reference signal ($s_{oa}(t)$) supplied to an demodulator (8, 12, 13) which also receives said intermediate frequency signal ($s_{IF}(t)$) and outputs a demodulated signal affected by phase noise; being said intermediate frequency reference signal ($s_{oa}(t)$) further supplied to said phase shifting means (5, 15) and first multiplying means (4, 17), obtaining a submultiple estimation voltage ($-\varphi/n$) at the output of said integrating means (7, 7', 21);
- means (26) for multiplying by ($n+1$) the submultiple estimation voltage ($-\varphi/n$), obtaining at the output of said second multiplying means (1, 9, 11) said demodulated postcompensated signal cleaned from phase noise ($g'(t)$).

4. The phase noise compensation circuitry of one of the preceding claims, **characterised in that** an analog-to-digital converter (20) clocked by a digital clock ($c_K(T_{CK})$) is placed downstream said first multiplying means (17) in order to obtain the sine and cosine phase noise compensation factors ($sin(\varphi)$, $cos(\varphi)$) digitally.

5. The phase noise compensation circuitry of claim 4, **characterised in that** said fixed delay $\tau$ spans an integer number $L$ of clock periods of said digital clock ($c_K(T_{CK})$).

6. The phase noise compensation circuitry of the claim 5, **characterised in that** said fixed delay $\tau$ spans an integer number $N>L$ of periods of said reference signal ($s_o(t)$).

7. The phase noise compensation circuitry of the claim 6, **characterised in that** $L>1$ and in correspondence $N>f_o/f_{CK}$ where $f_o$ is the frequency of said reference signal ($s_o(t)$) and $f_{CK}$ is the frequency of the digital clock ($c_K(T_{CK})$).

8. The phase noise compensation circuit of the claim 6, **characterised in that** $L=1$ and in correspondence $N=f_o/f_{CK}$ where $f_o$ is the frequency of said reference signal ($s_o(t)$) and $f_{CK}$ is the frequency of the digital clock ($c_K(T_{CK})$).

9. The phase noise compensation circuitry of any claim from 4 to 8, **characterised in that** said means (23, 24) for generating sine and cosine phase noise compensation factors ($sin(\varphi)$, $cos(\varphi)$) are implemented by look-up tables storing digital samples calculated to force the $2\pi$ cyclicity of the phase noise ($-\varphi$) to correspond to the overflow of the digital signal ($s_5(k)$) at the output of said integrating means (21).

10. The phase noise compensation circuitry of any claim from 4 to 9, **characterised in that** the frequency of said digital clock ($c_K(T_{CK})$) is equal to the frequency of a digital data stream at the input/output ($\{a_D\}$).

11. The phase noise compensation circuitry of one of the preceding claims from 4 to 10, **characterised in that** in presence of digital modulations/demodulations the cosine phase noise compensation factor ($cos(\varphi)$) is multiplied by the in-phase modulating/demodulated component ($\{s_I(r)\}$) and the sine phase noise compensation factor ($sins(\varphi)$) is multiplied by the in-quadrature modulating/demodulated component ($\{s_Q(r)\}$).

12. The phase noise compensation circuitry of one of the preceding claims from 4 to 10, **characterised in that** in presence of analog modulations/demodulations the transmitter includes a second analog-to-digital converter for digitally convert the analog modulating signal before multiplying it by the sine and cosine phase noise compensation factors ($sin(\varphi)$, $cos(\varphi)$).

13. The phase noise compensation circuitry of the preceding claim, **characterised in that** in presence of analog modulations/demodulations the receiver includes a digital-to-analog converter for analog converting the digital postcompensated signal.

# TRANSMITTER AND RECEIVER FOR ANALOG SIGNALS AND ANALOG PHASE NOISE COMPENSATION

**TRANSMITTER**

$g(t)$ → [TX PHASE NOISE PRECOMPENSATOR] 1 → $\tilde{g}(t)$ → [MODULATOR] 2 →

$-\varphi_{NT}$ ← [∫] 7 ← [×] 4 ← [π/2] 5 ← [~] 3

TX-PNES, [τ] 6

$c_{TX}(t) = \cos[\omega_o t + \varphi_{NT}(t)]$

**RECEIVER**

$g'(t)$ ← [RX PHASE NOISE POSTCOMPENSATOR] 9 ← [DEMODULATOR] 8 ←

$-\varphi_{NR}$ ← [∫] 7' ← [×] 4' ← [π/2] 5' ← [~] 3'

RX-PNES, [τ] 6'

$c_{RX}(t) = \cos[\omega_o t + \varphi_{NR}(t)]$

COMMUNICATION CHANNEL

**FIG. 1**

EP 1 443 640 A1

# TRANSMITTER FOR DIGITAL MODULATION AND DIGITAL PHASE NOISE PRECOMPENSATION

**FIG. 2**

$$s_o(t) = \cos(\omega_o t + \varphi(t))$$

EP 1 443 640 A1

# PARTIAL TRANSMITTER FOR ANALOG AM AND PM WITH DIGITAL PHASE NOISE PRECOMPENSATION

**FIG.3**

# PARTIAL TRANSMITTER FOR ANALOG FM WITH DIGITAL PHASE NOISE PRECOMPENSATION

**FIG.4**

# SPECTRAL COMPARISON BETWEEN UNCOMPENSATED AND PHASE NOISE COMPENSATED LOCAL OSCILLATIONS

**FIG.5**

**FIG. 6**

# DIGITAL PHASE NOISE COMPENSATION CONSIDERING FREQUENCY CONVERSION WITH PHASE NOISE DIVISION

**FIG.7**

EP 1 443 640 A1

**European Patent Office**

## EUROPEAN SEARCH REPORT

Application Number

EP 03 42 5048

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 661 439 A (WATKINS GRANT H ET AL) 26 August 1997 (1997-08-26) * column 6, line 56 - column 10, line 34; figures 6,9 * --- | 1-3 | H03B1/04 |
| Y | EP 0 933 903 A (ADVANCED DIGITAL TELEVISION BR ;TOKYO SHIBAURA ELECTRIC CO (JP)) 4 August 1999 (1999-08-04) * column 2, paragraph 19 - paragraph 27; figure 2 * ----- | 1-3 | |

**TECHNICAL FIELDS SEARCHED (Int.Cl.7)**

H03B

The present search report has been drawn up for all claims

| Place of search | Date of completion of the search | Examiner |
|---|---|---|
| THE HAGUE | 16 May 2003 | Beasley-Suffolk, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**
EP 03 42 5048

This annex lists the patent family members relating to the patent documents cited in the above-mentioned European search report.
The members are as contained in the European Patent Office EDP file on
The European Patent Office is in no way liable for these particulars which are merely given for the purpose of information.

16-05-2003

| Patent document cited in search report | | Publication date | Patent family member(s) | | Publication date |
|---|---|---|---|---|---|
| US 5661439 | A | 26-08-1997 | NONE | | |
| EP 0933903 | A | 04-08-1999 | JP<br>JP<br>EP | 2907804 B2<br>11220451 A<br>0933903 A2 | 21-06-1999<br>10-08-1999<br>04-08-1999 |